# FASCICULE DE BREVET EUROPEEN

(11) **EP 1 980 607 B1**
(45) Date de publication et mention de la délivrance du brevet: **02.03.2011**
(21) Numéro de dépôt: 08154174.0
(22) Date de dépôt: 08.04.2008
(51) Int. Cl.: C09K 13/08, H01L 21/306, H01L 21/3063

(54) **Solution utilisée dans la fabrication d'un matériau semi-conducteur poreux et procédé de fabrication dudit matériau**
Lösung, die bei der Herstellung eines porösen Halbleitermaterials verwendet wird, und Herstellungsverfahren dieses Materials
Solution used in the production of a porous semi-conductor material and method of manufacturing said material

(30) Priorité: 13.04.2007 FR 0754443
(43) Date de publication de la demande: 15.10.2008
(73) Titulaire: Altis Semiconductor, 91105 Corbeil Essonnes Cedex (FR)
(72) Inventeur: Delahaye, Bruno, 91520 Egly (FR); Baltzinger, Jean-Luc, 91210 Draveil (FR); Sanogo, Malamine, 91000 Evry (FR); Richou, Gaëlle, 91150 Etampes (FR)
(74) Mandataire: Feray, Valérie

(56) Documents cités:
- WO-A-2007/083152
- FR-A- 2 347 459
- US-A- 3 436 259
- US-A- 4 230 523
- US-A1- 2002 166 572

## Description

La présente invention se rapporte à une solution utilisée dans la fabrication d'un matériau semi-conducteur poreux, ainsi qu'à un procédé de fabrication dudit matériau.

Elle s'applique typiquement mais non exclusivement à la fabrication de matériaux semi-conducteurs poreux utilisés dans le domaine des cellules photovoltaïques, des cellules optoélectroniques et des capteurs chimiques ou biochimiques.

Le document US2002/0119663 décrit une solution dite « electroless », ou en d'autres termes ne nécessitant pas l'utilisation d'un courant électrique entre deux électrodes, permettant de fabriquer un matériau semi-conducteur poreux.

La solution comprend un complexe fluoré, ledit complexe étant préparé en dissolvant un élément métallique dans de l'acide fluorhydrique.

Cet élément métallique est typiquement choisi parmi le titane (Ti), le manganèse (Mn), le fer (Fe), le zirconium (Zr) ou le hafnium (Hf), et présente un potentiel d'oxydoréduction négatif par rapport à une électrode à hydrogène à 25°C.

Le procédé de fabrication d'un matériau semi-conducteur poreux consiste selon ce document à mettre en contact la surface d'un matériau semi-conducteur du type silicium avec la solution contenant le complexe fluoré afin de former des pores à la surface dudit matériau.

Toutefois, ce procédé présente l'inconvénient d'avoir une cinétique de réaction très lente pour former ledit matériau poreux.

En effet, la cinétique de réaction de formation des pores ayant une profondeur d'environ 150 nm à la surface du matériau silicium est d'au moins une demi-journée, plus particulièrement de 18 heures.

Ce type de procédé est donc difficilement applicable à une échelle industrielle.

Le document US 3 436 259 décrit un procédé pour polir des surfaces semi-conductrices en silicium à un degré élevé de perfection en surface, utilisant une solution comprenant du nitrate de cuivre et de l'acide fluorhydrique.

Le problème technique à résoudre, par l'objet de la présente invention, est de proposer une nouvelle solution permettant d'éviter les problèmes de l'état de la technique en offrant notamment une solution permettant de fabriquer un matériau semi-conducteur poreux de manière simple, rapide et économique.

La solution du problème technique posé réside, selon la présente invention, en ce que la solution comprend de l'acide fluorhydrique, un alcool ayant une viscosité supérieure à 5 mPa·s (5 centipoises) à 25°C; et un sel métallique dont le métal a un potentiel d'oxydoréduction positif par rapport à une électrode à hydrogène à 25°C.

Avantageusement, les pores formés à l'aide de ladite solution à la surface du matériau semi-conducteur sont du type anisotrope.

L'effet anisotropique de la solution permet ainsi d'obtenir des pores, ou en d'autres termes des trous en forme de tube cylindrique, de dimensions homogènes et unidirectionnels.

De plus, la cinétique de la réaction de formation des pores ainsi que la profondeur desdits pores peuvent être facilement contrôlées et optimisées en faisant varier au moins un paramètre choisi parmi :
- la température de la solution,
- la concentration de l'acide fluorhydrique,
- la concentration de l'alcool,
- la concentration du métal,
- le type d'alcool utilisé, et
- le potentiel d'oxydoréduction du métal.

De plus, la préparation de ladite solution est très simple et rapide, et ne nécessite pas d'étape préalable de dissolution.

Enfin, la solution présente une très bonne stabilité dans le temps et peut être facilement conservée.

Dans un mode de réalisation particulier, l'alcool a une viscosité de préférence supérieure à 10 mPa·s (centipoises) à 25°C.

Dans un autre mode de réalisation particulier, l'alcool est un diol, de préférence le diol est l'éthylène glycol.

Selon une caractéristique de l'invention, l'anion du sel métallique peut être avantageusement choisi parmi le NO₃⁻ et le SO₄²⁻.

Selon une autre caractéristique de l'invention, le métal du sel métallique est choisi parmi le cuivre (Cu), le platine (Pt), l'argent (Ag) et l'or (Au).

Plus particulièrement, le cuivre est le métal préféré car il est le plus économique.

Les potentiels d'oxydoréduction de ces métaux préférés sont détaillés dans le Tableau 1.

Ces potentiels sont établis par rapport à une électrode à hydrogène à 25°C.

**Tableau 1**

| Métal | Potentiel (V) |
|---|---|
| Cuivre | + 0,34 |
| Argent | + 0,80 |
| Platine | +1,2 |
| Or | +1,5 |

Dans un autre mode de réalisation particulier, le rapport molaire entre l'acide fluorhydrique et l'alcool est égal à 4:100.

Dans un autre mode de réalisation particulier, la solution comprend au moins 1 ppm de métal.

A partir de cette concentration, le nombre de trous et leur profondeur augmentent de façon significative.

Un autre objet de la présente invention est un procédé de fabrication d'un matériau semi-conducteur poreux comprenant la mise en contact de la surface d'un matériau semi-conducteur avec une solution conforme à l'invention.

Avantageusement, un courant d'électrolyse se crée dans la solution au fur et à mesure de la réaction électrochimique (oxydoréduction) entre le silicium et le métal du sel métallique.

Plus particulièrement, ce courant d'électrolyse est ainsi généré in situ entre d'une part le métal (cation) du sel métallique jouant le rôle d'une électrode de type cathode et d'autre part le matériau semi-conducteur jouant le rôle d'une électrode de type anode.

De plus, ce procédé permet d'obtenir une porosité homogène et anisotrope à la surface du matériau semi-conducteur.

De préférence, le matériau semi-conducteur est immergé dans ladite solution.

Dans un mode de réalisation préféré, la solution peut être chauffée et/ou exposée sous une lumière blanche afin d'accélérer la cinétique de formation des pores.

Plus particulièrement, la solution peut être chauffée à une température supérieure à 40°C.

Selon une caractéristique préférée de l'invention, le matériau semi-conducteur est du silicium cristallin (monocristallin ou polycristallin), de préférence du silicium monocristallin.

Selon une variante, le silicium cristallin peut être dopé p et/ou dopé n. Ainsi, la cinétique de la réaction de formation des pores ainsi que la profondeur desdits pores peuvent être facilement contrôlées et optimisées en faisant également varier la concentration des éléments dopants dans le silicium cristallin.

Lorsque le silicium cristallin est dopé n, il est préférable que la solution soit exposée sous une lumière blanche pour accélérer la cinétique de formation des pores.

Typiquement, le dopage de type p s'effectue par du bore et le dopage de type n s'effectue par du phosphore.

Le matériau semi-conducteur est de préférence en forme de plaque. L'une des faces de ladite plaque peut avantageusement être recouverte d'une couche externe d'un matériau diélectrique organique ou inorganique.

En effet, la présence de cette couche diélectrique externe permet d'augmenter la densité et/ou la profondeur des pores.

Dans un autre mode de réalisation particulièrement préféré, le procédé comprend en outre une étape de nettoyage du matériau semi-conducteur poreux à l'aide d'une composition oxydante.

Cette composition oxydante permet avantageusement l'élimination de tout dépôt métallique qui pourrait se former à la surface du matériau semi-conducteur lors de la formation des pores.

En effet, le matériau semi-conducteur peut être contaminé par un dépôt métallique en milieu acide fluorhydrique et en présence du sel métallique.

A titre d'exemple, lorsqu'un matériau de silicium est mis en contact avec un sel de cuivre en milieu acide fluorhydrique, il se produit les réactions électrochimiques suivantes :
Si + 6HF -> H₂SiF₆ + 4H⁺ + 4e⁻
2H⁺ + 2e⁻ -> H₂
Cu²⁺ + 2e⁻ -> Cu (dépôt métallique).

Ainsi, il est préférable d'éliminer, à l'aide d'une composition oxydante, le dépôt métallique de cuivre formé à la surface du matériau silicium afin d'éviter la diffusion du cuivre dans le silicium et de dégrader ce dernier.

Cette composition oxydante est de préférence choisie parmi la SC1, la SC2 et la SPM.

La compositions SC1 (Solution Clean n°1) se compose d'eau desionisée ultrapure, d'eau oxygénée et d'hydroxyde d'ammonium.

Par exemple, la composition en volume de la SC1 peut être de 5 :1 :1 (H₂O :H₂O₂ :NH₄OH) ou de 80 :3,1 :1,3 (H₂O :H₂O₂ :NH₄OH).

La composition SC2 (Solution Clean n°2) se compose d'eau desionisée ultrapure, d'eau oxygénée et d'acide chlorhydrique.

Par exemple, la composition en volume de la SC2 peut être de 5 :1 :1 (H₂O :H₂O₂ :HCl) ou de 80 :3,1 :2,2 (H₂O :H₂O₂ :HCl).

La composition SPM (Sulfuric Peroxide Mixture) se compose d'eau oxygénée et d'acide sulfurique.

Par exemple, la composition en volume de la SPM peut être de 4 :1 (H₂SO₄ : H₂O₂).

Bien entendu, l'étape de nettoyage du matériau semi-conducteur poreux peut comprendre l'utilisation successive de plusieurs compositions oxydantes.

Après avoir mis en contact le matériau semi-conducteur avec la solution selon la présente invention, le matériau semi-conducteur poreux obtenu peut ainsi être nettoyé en étant plongé dans un bain de ladite composition oxydante ou en étant simplement aspergé par cette dernière.

Dans un autre mode particulièrement préféré, le procédé ne comprend pas d'électrodes externes parcourues par un courant électrique, ces électrodes ayant un coût relativement élevé.

A titre d'exemples, il n'est pas nécessaire d'ajouter dans la solution une électrode métallique du type cathode en platine pouvant être associée à une anode en un matériau semi-conducteur, la cathode et l'anode étant parcourues par un courant électrique.

Un autre objet de la présente invention est l'utilisation de ladite solution pour la fabrication de cellules photovoltaïques, de cellules optoélectroniques et/ou de capteurs chimiques ou biochimiques.

D'autres caractéristiques et avantages de la présente invention apparaîtront à la lumière de l'exemple qui va suivre..

Une solution comprenant un mélange d'acide fluorhydrique, d'éthylène glycol et de CuSO₄ est préparé, l'éthylène glycol ayant une viscosité d'environ 16 mPa·s (centipoises) à 25°C.

Le rapport molaire entre l'acide fluorhydrique et l'éthylène glycol est de 4:100.

La quantité de métal du sel métallique CuSO₄ dans la solution est de 1 ppm.

Afin de fabriquer un matériau semi-conducteur poreux, on utilise dans ledit exemple une plaque circulaire de silicium monocristallin, de 200 mm de diamètre et de 700 µm d'épaisseur.

Cette plaque de silicium monocristallin est recouverte sur l'une de ses faces d'une couche externe d'un matériau diélectrique inorganique tel que du nitrure de silicium.

Une couche intermédiaire d'oxyde de silicium se trouve en outre entre la plaque de silicium monocristallin et la couche de nitrure de silicium pour éviter les contraintes mécaniques, bien connues de l'homme du métier, entre le nitrure de silicium et la plaque de silicium monocristallin.

Par conséquent, le dépôt de ladite couche externe sur la plaque de silicium monocristallin est dit indirect.

Bien entendu, la couche externe de matériau diélectrique organique ou inorganique peut également être déposée directement sur l'une des faces de la plaque de silicium monocristallin, ou en d'autres termes sans la présence d'une couche intermédiaire.

L'autre face de la plaque de silicium monocristallin, qui n'est pas recouverte par ladite couche externe et qui est en contact avec la solution, est appelée face active. Dans le cas où la plaque de silicium n'est pas recouverte d'une couche externe, ladite plaque comprend deux faces actives.

La plaque de silicium monocristallin recouverte sur l'une de ses faces de la couche externe est alors immergée pendant 7 minutes dans un bain thermostaté de cette solution métallique, ladite solution étant à une température de 85°C.

La plaque ainsi obtenue est sortie du bain thermostaté et rincée à l'eau.

On obtient alors une plaque de silicium monocristallin poreux comportant des pores homogènes sur toute la surface de ladite plaque, ou plus particulièrement des pores homogènes sur toute la face active de ladite plaque.

Ces pores sont des trous en forme de tube cylindrique qui s'étendent perpendiculairement à la surface de ladite plaque (ou face active), chacun de ces trous étant ainsi sensiblement parallèles les uns avec les autres.

Ces pores, formés anisotropiquement à la surface de ladite plaque, ont une profondeur comprise entre 150 et 250 nm, et un diamètre compris entre 15 et 30 nm.

Il est bien entendu possible d'utiliser des masques de gravures positionnés sur la surface du matériau semi-conducteur, ou tout autre technique bien connue de l'homme du métier, pour localiser préférentiellement la formation des pores.

## Revendications

1. Solution destinée à être utilisée dans la fabrication d'un matériau semi-conducteur poreux, comprenant :
- de l'acide fluorhydrique,
- un alcool ayant une viscosité supérieure à 5 mPa.s (centipoises) à 25°C, et
- un sel métallique dont le métal a un potentiel d'oxydoréduction positif par rapport à une électrode à hydrogène à 25°C.

2. Solution selon la revendication 1, **caractérisée en ce que** l'alcool est un diol, de préférence l'éthylène glycol.

3. Solution selon la revendication 1 ou 2, **caractérisée en ce que** l'anion du sel métallique est choisi parmi le NO₃⁻ et le SO₄²⁻.

4. Solution selon l'une quelconque des revendications précédentes, **caractérisée en ce que** le métal du sel métallique est choisi parmi le cuivre (Cu), le platine (Pt), l'argent (Ag) et l'or (Au), de préférence le cuivre.

5. Solution selon l'une quelconque des revendications précédentes, **caractérisée en ce que** le rapport molaire entre l'acide fluorhydrique et l'alcool est égal à 4:100.

6. Solution selon l'une quelconque des revendications précédentes, **caractérisée en ce qu'**elle comprend au moins 1 ppm de métal du sel métallique.

7. Procédé de fabrication d'un matériau semi-conducteur poreux comprenant la mise en contact de la surface d'un matériau semi-conducteur avec une solution telle que définie aux revendications précédentes.

8. Procédé de fabrication selon la revendication 7, **caractérisé en ce que** le matériau semi-conducteur est immergé dans ladite solution.

9. Procédé de fabrication selon la revendication 7 ou 8, **caractérisé en ce que** la solution est chauffée, de préférence à une température supérieure à 40°C.

10. Procédé de fabrication selon l'une quelconque des revendications 7 à 9, **caractérisé en ce que** la solution est exposée sous une lumière blanche.

11. Procédé de fabrication selon l'une quelconque des revendications 7 à 10, **caractérisé en ce que** le matériau semi-conducteur est du silicium cristallin, de préférence du silicium monocristallin.

12. Procédé de fabrication selon la revendication 11, **caractérisé en ce que** le silicium cristallin est du silicium dopé p et/ou dopé n.

13. Procédé de fabrication selon l'une quelconque des revendications précédentes, **caractérisé en ce que** le matériau semi-conducteur est une plaque dont l'une des faces est recouverte d'une couche externe d'un matériau diélectrique.

14. Procédé de fabrication selon l'une quelconque des revendications 7 à 13, **caractérisé en ce qu'**il comprend en outre une étape de nettoyage du matériau semi-conducteur poreux à l'aide d'une composition oxydante.

15. Procédé de fabrication selon la revendication 14, **caractérisé en ce que** la composition oxydante est choisie parmi la SC1, la SC2 et la SPM.

16. Procédé de fabrication selon l'une quelconque des revendications 7 à 15, **caractérisé en ce qu'**il ne comprend pas d'électrodes externes parcourues par un courant électrique.

## Claims

1. A solution intended to be used in the manufacturing of a porous semiconducting material, comprising:
- hydrofluoric acid,
- an alcohol with a viscosity of more than 5 mPa.s (centipoises) at 25° C, and
- metal salt, the metal of which has a positive oxidation-reduction potential with respect to a hydrogen electrode at 25° C.

2. The solution according to claim 1, **characterized in that** the alcohol is a diol, preferably ethylene glycol.

3. The solution according to claim 1 or 2, **characterized in that** the anion of the metal salt is selected from NO₃- and SO₄²⁻.

4. The solution according to any of the preceding claims, **characterized in that** the metal of the metal salt is selected from copper (Cu), platinum (Pt), silver (Ag) and gold (Au), preferably copper.

5. The solution according to any of the preceding claims, **characterized in that** the molar ratio between hydrofluoric acid and the alcohol is equal to 4:100.

6. The solution according to any of the preceding claims, **characterized in that** it comprises at least 1 ppm of metal of the metal salt.

7. A method for manufacturing a poorer semiconducting material comprising the contacting of the surface of a semiconducting material with a solution as defined according to the preceding claims.

8. The manufacturing method according to claim 7, **characterized in that** the semiconducting material is immersed in said solution.

9. The manufacturing method according to claim 7 or 8, **characterized in that** the solution is heated, preferably at a temperature above 40°C.

10. The manufacturing method according to any of claims 7 to 9, **characterized in that** the solution is exposed under white light.

11. The manufacturing method according to any of claims 7 to 10, **characterized in that** the semiconducting material is crystalline silicon, preferably single-crystal silicon.

12. The manufacturing method according to claim 11, **characterized in that** the crystalline silicon is p doped and/or n doped silicon.

13. The manufacturing method according to any of the preceding claims, **characterized in that** the semiconducting material is a plate, one of the faces of which is covered with an external layer of a dielectric material.

14. The manufacturing method according to any of claims 7 to 13, **characterized in that** it further comprises a step for cleaning the porous semiconducting material with an oxidizing composition.

15. The manufacturing method according to claim 14, **characterized in that** the oxidizing composition is selected from SC1, SC2 and SPM.

16. The manufacturing method according to any of claims 7 to 15, **characterized in that** it does not comprise any external electrodes through which an electric current flows.

## Patentansprüche

1. Lösung zur Verwendung bei der Herstellung eines porösen Halbleitermaterials, die umfasst:
- Fluorwasserstoffsäure,
- einen Alkohol mit einer Viskosität über 5 mPa·s (Zentipoise) bei 25 °C, und
- ein Metallsalz, dessen Metall bei 25 °C ein positives Redoxpotential im Verhältnis zu einer Wasserstoffelektrode hat.

2. Lösung nach Anspruch 1, **dadurch gekennzeichnet, dass** der Alkohol ein Diol ist, vorzugsweise Ethylenglykol.

3. Lösung nach Anspruch 1 oder 2, **dadurch gekennzeichnet, dass** das Anion des Metallsalzes aus dem NO₃ und dem SO₄²⁻ ausgewählt ist.

4. Lösung nach einem der vorangehenden Ansprüche, **dadurch gekennzeichnet, dass** das Metall des Metallsalzes aus dem Kupfer (Cu), dem Platin (Pt), dem Silber (Ag) und dem Gold (Au), vorzugsweise dem Kupfer, ausgewählt ist.

5. Lösung nach einem der vorangehenden Ansprüche, **dadurch gekennzeichnet, dass** das molare Verhältnis zwischen der Fluorwasserstoffsäure und dem Alkohol gleich 4:100 ist.

6. Lösung nach einem der vorangehenden Ansprüche, **dadurch gekennzeichnet, dass** sie mindestens 1 ppm Metall des Metallsalzes umfasst.

7. Verfahren zur Herstellung eines porösen Halbleitermaterials, das das Kontaktieren der Oberfläche eines Halbleitermaterials mit einer Lösung umfasst, wie in den vorangehenden Ansprüchen definiert.

8. Verfahren nach Anspruch 7, **dadurch gekennzeichnet, dass** das Halbleitermaterial in die Lösung eingetaucht wird.

9. Herstellungsverfahren nach Anspruch 7 oder 8, **dadurch gekennzeichnet, dass** die Lösung erhitzt wird, vorzugsweise auf eine Temperatur über 40 °C.

10. Herstellungsverfahren nach einem der Ansprüche 7 bis 9, **dadurch gekennzeichnet, dass** die Lösung einem weißen Licht ausgesetzt wird.

11. Herstellungsverfahren nach einem der Ansprüche 7 bis 10, **dadurch gekennzeichnet, dass** das Halbleitermaterial kristallines Silizium ist, vorzugsweise monokristallines Silizium.

12. Herstellungsverfahren nach Anspruch 11, **dadurch gekennzeichnet, dass** das kristalline Silizium p-dotiertes und/oder n-dotiertes Silizium ist.

13. Herstellungsverfahren nach einem der vorangehenden Ansprüche, **dadurch gekennzeichnet, dass** das Halbleitermaterial eine Platte ist, von der eine der Seite mit einer externen Schicht eines dielektrischen Materials bedeckt ist.

14. Herstellungsverfahren nach einem der Ansprüche 7 bis 13, **dadurch gekennzeichnet, dass** es weiterhin einen Schritt der Reinigung des porösen Halbleitermaterials mit Hilfe einer oxidierenden Verbindung umfasst.

15. Herstellungsverfahren nach Anspruch 14, **dadurch gekennzeichnet, dass** die oxidierende Verbindung aus dem SC1, dem SC2 und dem SPM ausgewählt ist.

16. Herstellungsverfahren nach einem der Ansprüche 7 bis 15, **dadurch gekennzeichnet, dass** es keine externen Elektroden umfasst, die von einem elektrischen Strom durchflossen werden.
